# EUROPEAN PATENT SPECIFICATION

(11) **EP 2 302 851 B1**
(45) Date of publication and mention of the grant of the patent: **18.04.2012**
(21) Application number: 09290738.5
(22) Date of filing: 29.09.2009
(51) Int. Cl.: H04L 25/02, H03F 1/02

(54) **Power supply arrangement for line termination units**
Stromversorgungsanordnung für Leitungsabschlusseinrichtungen
Agencement d'alimentation électrique pour unités de terminaison de ligne

(43) Date of publication of application: 30.03.2011
(73) Proprietor: Alcatel Lucent, 75007 Paris (FR)
(72) Inventor: van den Berg, Eric, 2560 Nijlen (BE); Troch, Wim, 2830 Tisselt (BE)
(74) Representative: Anderlini, Alain

(56) References cited:
- EP-A1- 1 317 105
- EP-A1- 1 998 521
- EP-A2- 0 687 060
- WO-A1-01/78248
- WO-A1-99/18662
- JP-A- 3 104 408

## Description

### Technical Field of the invention

The present invention relates to a power supply arrangement within a line termination unit for reducing its power consumption and ecological footprint.

### Technical Background of the Invention

A Digital subscriber Line Access Multiplexer (DSLAM) typically comprises line termination units for physically terminating copper transmission lines from customer premises.

A line termination unit accommodates specific analog circuitry for connecting to the transmission lines, such as line drivers, hybrids, transformers, etc. The line driver is an analog front-end device for shaping, amplifying and driving the analog transmit signal onto the transmission line.

The line termination units are responsible for about 80% of the total system power consumption. The line drivers themselves are responsible for half of the line termination unit power consumption.

The power consumption of a line driver driving a copper line with a very Nigh speed Digital subscriber Line (VDSL) signal is about 0,8 - 1 w, which is significantly higher than the maximum power of 100 mw which can be put on the line. Yet, the actual transmit power closely depends on the selected transmission profile and the required power level to achieve a certain service Level Agreement (SLA), such as a certain data throughput with a certain Quality of service (QoS).

The minimum supply voltage with which a line driver needs to be powered depends on the peak amplitude of the signal to be output. For a DSL signal, this peak amplitude is typically 5 to 6 times the amplitude of the Root Mean Square (RMS) value.

In order to keep the cost of a line termination unit within reasonable limits, all line drivers are powered from a single power supply converter. The output voltage of this power supply is fixed at the minimum supply voltage required by the worst case profile and/or output power. As a result of this, all lines which are configured with a lower output power or with a less demanding profile have their line driver operating at a supply voltage which is higher than required and consequently waste energy.

on some designs, the output voltage of the power supply unit providing the supply voltage to all the line drivers has been made selectable between two or more levels, or within a pre-determined voltage range. However, since all the line drivers share the same DC/DC converter, the probability that one of these lines is configured with a profile that requires high output power and/or that the line characteristics are actually demanding maximum power is very high. As such, all the line drivers are running with the highest selectable supply voltage for most of the time.

A power supply with a selectable or tunable output voltage has some disadvantages as well:
- The efficiency of a DC/DC converter reaches its maximum at only one particular output voltage. Any output voltage above or below this optimum will cause the efficiency to fall by a few percent.
- As the output voltage changes, the internal gain setting of the power supply changes as well. This increases the complexity of making sure that the converter is stable in all possible operational conditions. Solving this added complexity results in a higher design cost.

There are other solutions as well.

Typical VDSL line drivers are class-AB amplifiers. class-G or class-H amplifiers are known to be more power efficient.

A class-G line driver has 4 power supply terminals instead of just 2 for a class-AB line driver. The first set of power supply terminals is coupled to low symmetrical voltage supply rails (e.g., +/- 6 V), and the second set of power supply terminals is coupled to high symmetrical voltage supply rails (e.g., +/- 9 v). AS long as the amplitude of the output signal is low, the output stage of the amplifier is powered from the low voltage supply terminals. when the output voltage must rise to a higher level, the amplifier is momentarily powered from the high voltage supply rails.

Although this significantly lowers the average power consumed by the line driver, this technique has a number of disadvantages:
- while a class-AB amplifier can be powered asymmetrically, i.e. between the ground reference voltage and a single supply rail, a class-G amplifier requires at least 3 supply rails and all typical class-G amplifiers use 4 supply rails (i.e. a low and a high symmetrical voltage). The generation of these four supply voltages does not only make the power supply more expensive and bulkier, the distribution of these 3 additional supply rails requires more copper layers in the Printed circuit Board (PCB) making the line termination unit even more expensive.
- class-G line drivers are available for ADSL. For VDSL, class-G line drivers are just starting to sample. However, due to VDSL operating at higher frequency, most if not all class-G VDSL line drivers are not capable of autonomously detecting when they need to switch-over to the high supply rails. Thus a control signal is required to continuously steer the class-G line driver into using the correct set of supply rails.
- The fact that class-G line drivers are just emerging causes them not to be interchangeable. As such they do not fit the multi-sourcing strategy applied by most equipment manufacturers.
- The on-the-fly switch-over from one set of supply rails to another requires a complex technique. Mastering this technique requires state of the art technology, which causes the class-G line drivers to be more expensive than class-AB ones.

A class-H line driver has only two supply terminals, similar like the class-AB ones. A class-H line driver is internally equipped with charge pumps. when output voltage must rise to a higher level, the charge pumps are turned on and gradually raise the supply voltages applied to the line driver's output stage in a way that the desired output voltage can be created without any distortion, since the power supply rail of the output stage is only increased up to the level which is needed for the momentary output voltage, class-H line drivers promise to provide an even higher power reduction compared to class-G ones,

still, the class-H line drivers have a number of disadvantages:
- only one manufacturer has announced to own the technology
- which is required to build a VDSL-capable class-H line driver. However no samples are available at this time. And similar to the class-G line drivers, this is not compatible with the multi-sourcing strategy.
- Being a complex technology delivered by just a single manufacturer, it is expected to be a quite expensive technique.
- Besides the more expensive line driver, material costs are further increased due to the external capacitors required by the charge pump. These capacitors also require extra room on the board.

There is also the so-called 'gated class-H' line driver, i.e. some kind of class-G line driver which internally generates the high voltage supply rails and also requires an external control signal for switching the power supply voltage. Therefore this 'gated class-H' line driver will not deliver the power gain promised by a true class-H line driver but be more comparable to a class-G line driver (or even worse due to the efficiency losses in the charge pumps).

### Summary of the Invention

It is an object of the present invention to overcome the aforementioned shortcomings of the prior art and to provide a low-cost solution for reducing the power consumption of a line termination unit.

In accordance with a first aspect of the invention, a line termination unit comprises:
- a plurality of line drivers for driving respective ones of a plurality of transmission lines, with first supply voltage input terminals and second supply voltage input terminals,
- a power supply means, with an analog supply voltage output terminal for feeding an analog part of said line termination unit, and at least one digital supply voltage output terminal for feeding a digital part of said line termination unit, and
- a ground voltage reference,
wherein said analog supply voltage output terminal is coupled to said first supply voltage input terminals,
and wherein said line termination unit further comprises a selector for selectively and individually coupling said second supply voltage input terminals to one of said at least one digital supply voltage output terminal or to said ground voltage reference.

Instead of selecting or tuning the analog supply voltage output coupled to the high supply voltage input terminal of the line driver, the low supply voltage input terminal is selectively coupled to either the ground return or to one of the supply voltage outputs that are typical used for feeding the digital section of the line termination unit (e.g., +5V output for TTL circuits, +3, 3v output for LVTTL circuits, 2,5V output for DDR1 memory chips or for GB Ethernet, +1,8V output for DDR2 memory chips, etc).

Since this selective coupling can be achieved by means of e.g. low cost FET switches, this solution can be applied on a per line driver basis or group of line driver basis and is commercially attractive. Thus it becomes possible to select the most optimum supply voltage, in terms of power dissipation, in function of the large diversity of supported line profiles and output power levels.

The power consumption of a line termination unit is an important factor for DSL operators: an operator is willing to pay premium prices in order to reduce the operational expenditures (OPEX) of its installed base of DSLAMS.

In one embodiment of the invention, the line termination unit further comprises a controller for controlling the operation of said selector according to at least one line parameter.

The power supply of each line driver is dynamically adjusted according to one or more line parameters of the respective line, thereby optimally tunning each and every line driver's supply voltage.

In one embodiment of the invention, said at least one line parameter comprises an operator-adjustable transmission profile to be used over a transmission line.

The transmission profile determines the spectrum and power characteristics which the signal shall conform to, and thus the signal Peak-to-Average Ratio (PAR) which the line driver shall support. The signal PAR in turn determines the adequate voltage range with which the line driver shall be fed.

In one embodiment of the invention, said at least one line parameter comprises a measurable channel characteristic of a transmission line.

Such a measurable channel characteristic is for instance the electrical 1 length or alike of the transmission line, which controls in-fine the actual transmit power that is required over that specific transmission line. Such a measurable channel characteristics can be obtained from Single End Line Testing (SELT) or Dual End Line Testing (DELT).

Such a channel characteristic may also be measured in show time as part of the normal transceiver operation, such as a Signal to Noise Ratio (SNR) that is used for determining the respective carrier bit loadings and gains based on an achievable Bit Error Rate (BER) and expected coding gains.

In one embodiment of the invention, said at least one line parameter comprises a communication parameter determined during past operation of a communication session over a transmission line.

In an alternative embodiment of the invention, said at least one line parameter comprises a communication parameter determined during current operation of a communication session over a transmission line.

Such a communication parameters may refer for instance to the relative channel gain (also called gi), and/or Power Spectral 1 Density (PSD) shaping coefficients (also called tssi coefficient or PSD mask), which communication parameters yielding the actual transmit power over a particular transmission line.

The controller can use the communication parameters of a past communication session, as stored in a non-volatile memory area, or alternatively the communication parameters of the current session as in force in the transceiver unit.

Further characterizing embodiments are mentioned in the appended claims.

The European patent application EP 1998521, entitled "A Power Efficient Line Driver in a Digitial Subscriber Line Data Transmission System", published on December 3, 2008, discloses a power supply selector adapted to select between two power supply voltage references (VCC1, VCC2) for connection to a power supply input of an amplifier.

The PCT patent application wo 01/78248, entitled "Method and Arrangement for Minimizing Power Dissipation in a Line Driver", published on October 18, 2001, discloses a method for feeding a line driver with the most suitable power supply voltage according to characteristics of the communication channel (e.g., SNR).

### Brief Description of the Drawings

The above and other objects and features of the invention will become more apparent and the invention itself will be best understood by referring to the following description of an embodiment taken in conjunction with the accompanying drawings wherein:
- fig. 1 represents a prior art solution for power feeding line drivers,
- fig. 2 represents a line termination unit with a first power supply arrangement according to the invention,
- fig. 3 represents a line termination unit with a second power supply arrangement according to the invention,
- fig. 4 represents a line termination unit with a third power supply arrangement according to the invention.

### Detailed Description of the Invention

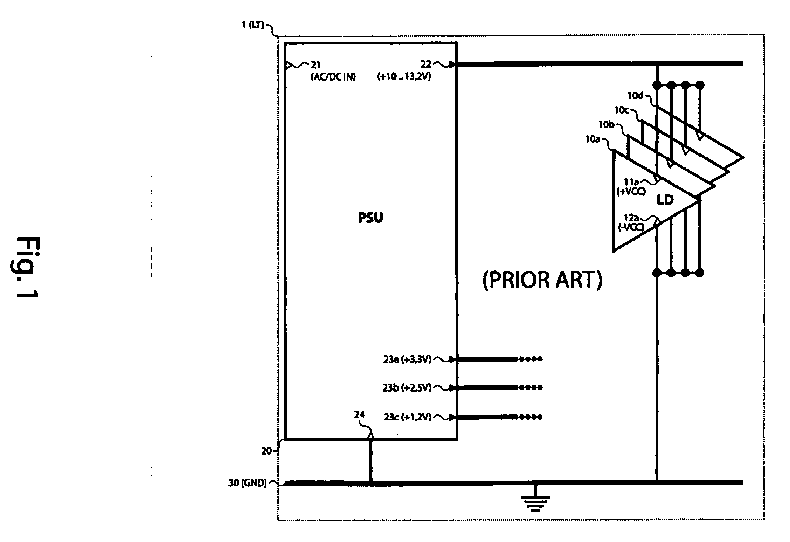

There is seen in fig. 1 a line termination unit 1 (or LT) comprising the following functional blocks:
- line drivers 10 (or LD),
- a power supply unit 20 (or PSU), and
- a ground voltage reference 30 (or GND) acting as a common return path for electric currents.

By convention, output terminals are drawn as plain triangle, and input terminals are drawn as hollow triangles. The power trails and the ground return path are drawn as thick lines.

As an illustrative embodiment, four line drivers 10a to 10d have been drawn.

The power supply unit 20 comprises a supply voltage input terminal 21 (or AC/DC IN) coupled to a DC or AC power source (not shown), such as -48v/-60v from a battery or 110/220v (RMS value) from an AC power utility, and a ground reference input terminal 24 coupled to the ground voltage reference 30.

The power supply unit 20 further comprises one or more voltage regulators and further circuitry (e.g., capacitors) for providing a first analog supply voltage output reference through a first supply voltage output terminal 22, and further digital supply voltage output references through further supply voltage output terminals 23.

The analog supply voltage output feeds an analog part of the line termination unit 1, which comprises inter alia the line drivers 10, and is made selectable within a pre-determined voltage range, presently from +10V to +13,2v. Yet, the power supply unit 20 is designed for optimal efficiency at a particular voltage output value, e.g. at +13,2v.

The further digital voltage outputs feed respective digital parts of the line termination unit 1. As an illustrative embodiment, three digital supply voltage output terminals 23a, 23b and 23c have been drawn supplying respectively 3,3v, 2,5v and 1,2v as digital supply voltage output references.

In the prior art solution, the line drivers 10 are powered asymmetrically, that is to say all the positive supply voltage input terminals 11 (or +VCC) of the line drivers 10 are coupled to the analog supply voltage output terminal 22 of the power supply unit 20, and all the negative supply voltage input terminals 12 (or -VCC) of the line drivers 10 are coupled to the ground voltage reference 30.

A symmetrical analog power supply may alternatively be used to power the line drivers 10, such as +9V and -9V analog supply voltage output references coupled to all the positive supply voltage input terminals 11 and all the negative supply voltage input terminals 12 of the line drivers 10 respectively.

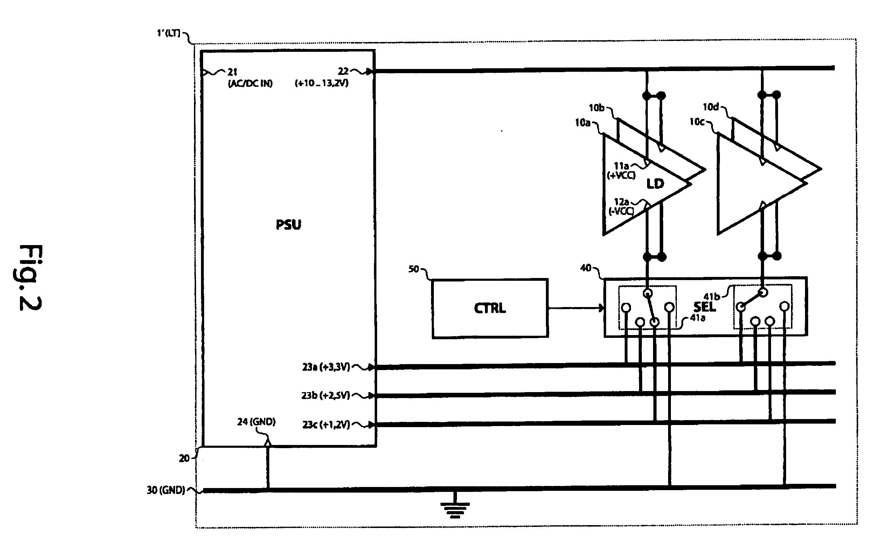

There is seen in fig. 2 a line termination unit 1' with a first power supply arrangement according to the invention.

The line termination unit 1' comprises the following functional blocks:
- the line drivers 10,
- the power supply unit 20,
- the ground voltage reference 30,
- a selector 40 (or SEL), and
- a controller 50 (or CTRL).

In this embodiment, all the positive supply voltage input terminals 11 of the line drivers 10 are still coupled to the analog supply voltage output terminal 22 of the power supply unit 20, yet the negative supply voltage input terminals 12 of the line drivers 10 are individually coupled through the selector 40 either to the ground voltage reference 30, or to one of the digital supply voltage output terminals 23 of the power supply unit 20. As such, a line driver can be configured to operate at either 13,2v, 12,0v, 10,7v or 9,9v (assuming the analog supply voltage output reference is adjusted to the optimum value +13,2v), whichever is the most suitable for the selected line profile or output power.

one can achieve even lower supply voltages for the line drivers by tuning the analog supply voltage output reference down to e.g. 10v, namely 10v, 8,8v, 7,5v or 6,7v.

It is to be noticed that the DC bias introduced in the transmit signal by such a power supply arrangement is typically filtered out by the transformer (not shown) that isolates the transceiver circuitry from the transmission line.

The selector 40 comprises switches 41 such as low-cost FET switches or alike. Each line driver can be assigned a dedicated switch so as to individually control its power supply voltage, or alternatively two or more line drivers can share the same return voltage selection switch (for cost reduction). As an illustrative embodiment, the line drivers 10 have been grouped by pairs, respectively line driver pairs {10a, 10b} and {10c, 10d}, each pair being coupled to respective switch 41a and 41b of the selector 40.

The controller 50 is coupled to the selector 40 and dynamically controls the operation of the selector 40. More specifically, the controller 50 dynamically controls the position of the switches 41 according to the power requirements of the corresponding line driver or group of line drivers coupled thereto.

The optimal supply voltage is a function of the actual downstream aggregate transmit power of the related line driver or group of line drivers. This data is typically available after the initialization sequence is finalized and transceivers are synchronized. However, the line driver supply voltage switch should preferably be controlled prior to the initialization sequence in order to avoid transient effects during show time. Hence this selection shall be based on individual configuration data such as the line transmission profile and/or further power limitations, and/or on loop plant estimates obtained from SELT or DELT measurements, and/or on relaxed requirements such as a relaxed BER, and/or on historical data from previous initializations.

One requirement, is that the current draw of each of the selectable supply rails of the digital section is higher than the current draw of all the line drivers. The supply rails of the digital section for which this can not be guaranteed need to be of the 'sink/source' type instead of having only a sourcing capability. For most typical designs, this requirement is easily met.

The number of supply rails from the digital section into which the line driver's current can be returned may differ from application to application. Not all the supply voltage rails of the digital section need to serve as possible return voltage rail.

Note that the supply voltages mentioned in this description are typical values. As technology evolves or when deviating board specifications must be met, other voltage levels may be selected.

As an example, +24v line drivers can be used, in which case the bus voltage, typically +5v or +6v, from which the digital supply voltages are being generated, may additionally be used to create +18v or +19v, in addition to +22,8v, 21,5v and 20,7V.

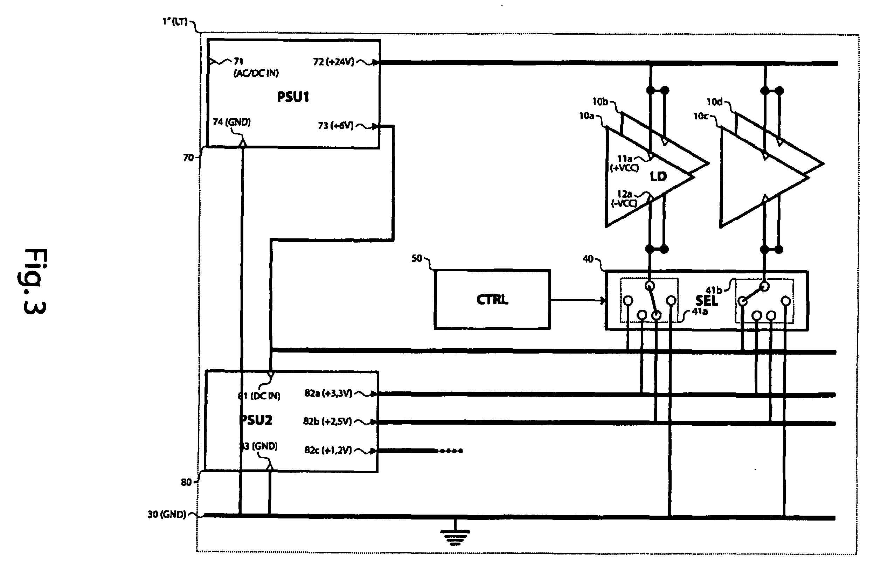

This configuration is depicted in fig. 3, wherein a further line termination unit 1" is shown as comprising the following functional blocks:
- the line drivers 10,
- a first power supply unit 70 (or PSU1),
- a second power supply unit 80 (or PSU2),
- the ground voltage reference 30,
- the selector 40, and
- the controller 50.

The first power supply unit 70 comprises a supply voltage input terminal 71 coupled to a DC or AC power source, and a ground reference input terminal 74 coupled to the ground voltage reference 30.

The first power supply unit 70 provides a first analog supply voltage output reference through a first supply voltage output terminal 72, presently +24v, for feeding an analog part of the line termination unit 1", and a second supply voltage output reference through a second supply voltage output terminal 73, presently +6v, for feeding inter alia the second power supply unit 80.

The second power supply unit 80 comprises a supply voltage input terminal 81 (or DC IN) coupled to the supply voltage output terminal 73 of the first power supply unit 70, and a ground reference input terminal 83 coupled to the ground voltage reference 30.

The second power supply unit 80 provides digital supply voltage output references through supply voltage output terminals 82, presently three digital supply voltage output terminals 82a, 82b and 82c supplying respectively 3,3v, 2,5v and 1,2v as digital voltage output references.

All the positive supply voltage input terminals 11 (or +VCC) of the line drivers 10 are coupled to the analog supply voltage output terminal 72 of the first power supply unit 70, and the negative supply voltage input terminals 11 of the line drivers 10 are individually coupled through the selector 40 either to the ground voltage reference 30, or to the supply voltage output terminal 73 of the first power supply unit 70, or to one of the digital supply voltage output terminals 82 of the second power supply unit 80.

Instead of using a high positive analog supply voltage, a negative analog supply voltage could be used as common supply terminal for the line drivers. The other supply terminals of the line drivers are again individually coupled either to the ground return or any of the supply rails of the digital section of the board.

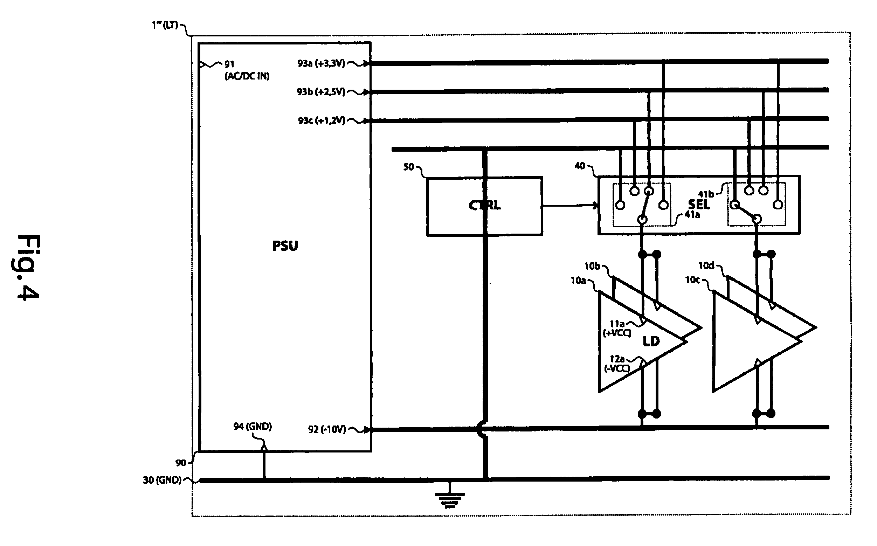

This configuration is depicted in fig. 4, wherein a further line termination unit 1'" is shown as comprising the following functional blocks:
- the line drivers 10,
- another power supply unit 90.
- the ground voltage reference 30,
- the selector 40, and
- the controller 50.

The power supply unit 90 comprises a supply voltage input terminal 91 coupled to a DC or AC power source, and a ground reference input terminal 94 coupled to the ground voltage reference 30.

The power supply unit 90 provides a negative analog supply voltage output reference through a supply voltage output terminal 92, presently -10V, and further positive digital supply voltage output references through further supply voltage output terminals 93, presently three digital supply voltage output terminals 93a, 93b and 93c supplying respectively 3,3V, 2,SV and 1,2V as digital supply voltage output references.

In this embodiment, all the negative supply voltage input terminals 12 of the line drivers 10 are coupled to the negative analog supply voltage output terminal 92 of the power supply unit 90, and the positive supply voltage input terminals 11 of the line drivers 10 are individually coupled through the selector 40 either to the ground voltage reference 30, or to one of the digital supply voltage output terminals 93 of the power supply unit 90. As such, a line driver can be configured to operate at either 13,3v, 12,5v, 11,2v or 10v, whichever is most suitable for the selected line profile or output power.

It should be noted however that this configuration is less efficient when compared to the first and second embodiment. In the first and second embodiment, the return current of the line driver is actually delivering part of the current consumed on the digital supply rail the line driver is connected to. In the third embodiment, a digital supply rail which also powers a line driver has to deliver the current drawn by the line driver on top of the current consumed by the digital section. At first glance this looks to actually consume more power, this is not the case since the negative supply voltage of the third embodiment can be reduced compared to the first and second embodiment. However, a power output which needs to deliver more current typically has higher RI² losses. As such this third embodiment will consume slightly more power since the efficiency of the converter is less.

It is noteworthy to mention that, besides the two power terminals, most line drivers have a further input terminal which serves as a reference voltage for the digital input signals setting the line driver's bias current. This reference voltage (and the amplitude of the bias setting signals on top of that) must remain within the supply voltage range [-VCC;+VCC].

In configurations as shown in fig. 2 or 3, this further input terminal needs to be coupled to the negative power supply input terminal 12 of the line driver, or to the highest digital supply voltage output terminal. Then a 'level shifter' (consisting of 3 resistors) is needed to translate the bias control signals generated by the digital components to the appropriate level.

In a configuration like the one of fig. 4, this reference voltage remains connected to the ground reference and the bias control lines do not require level shifters.

It is to be noticed that for a line termination unit which is able to generate 18dBm or 20dBm output power (e.g., ADSL or VDSL 8b profile) and equipped with class-G or class-H line drivers, these class-G or class-H line drivers do not deliver any gain in power consumption for lines configured to operate at 14.5dBm or less (e.g., 17a VDSL transmission profile or any other profile with downstream power-cut-back enabled). On the contrary, the control circuitry or charge-pump required for class-G and class-H line drivers to operate may consume a minor amount of power while being fully non-functional and making those newer line driver technologies more power consuming than in this proposed solution with class-AS line drivers.

Although the invention has been described with exhaustive- references to DSL technology and equipment, it is applicable to any piece of equipment suitable for terminating a transmission line, such a piece of equipment may form part of an access node, a router, a bridge, a multiplexer, an optical unit, a repeater, etc, and the transmission line may refer to an unshielded Twisted pairs (UTP such as CAT3/CAT5 cable), a coaxial cable, a power feeding line (for PCL), an optical fiber, etc.

It is to be noticed that the term 'comprising', also used in the claims, should not be interpreted as being restricted to the means listed thereafter. Thus, the scope of the expression 'a device comprising means A and B' should not be limited to devices consisting only of components A and B. It means that with respect to the present invention, the relevant components of the device are A and B.

It is to be further noticed that the term 'coupled', also used in the claims, should not be interpreted as being restricted to direct connections only. Thus, the scope of the expression 'a device A coupled to a device B' should not be limited to devices or systems wherein an output of device A is directly connected to an input of device B, and/or vice-versa. It means that there exists a path between an output of A and an input of B, and/or vice-versa, which may be a path including other devices or means.

The description and drawings merely illustrate the principles of the invention. All examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles and aspects of the invention, as well as specific examples thereof, are intended to encompass equivalents thereof.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, a processor should not be construed to refer exclusively to hardware capable of executing software, and may implicitly include, without limitation, digital signal processor (DSP) hardware, network processor, application specific integrated circuit (ASIC), field programmable gate array (FPGA), etc. other hardware, conventional and/or custom, such as read only memory (ROM), random access memory (RAM), and non volatile storage, may also be included.

## Claims

1. A line termination unit (1') comprising:
- a plurality of line drivers (10) for driving respective ones of a plurality of transmission lines, with first supply voltage input terminals (11) and second supply voltage input terminals (12),
- a power supply means (20), with an analog supply voltage output terminal (22) for feeding an analog part of said line termination unit, and at least one digital supply voltage output terminal (23a, 23b, 23c) for feeding a digital part of said line termination unit, and
- a ground voltage reference (30),
wherein said analog supply voltage output terminal is coupled to said first supply voltage input terminal,
and wherein said line termination unit further comprises a selector (40) for selectively and individually coupling each of said second supply voltage input terminals to one of said at least one digital supply voltage output terminal or to said ground voltage reference.

2. A line termination unit (1') according to claim 1, and further comprising a controller (50) for controlling the operation of said selector according to at least one line parameter.

3. A line termination unit (1') according to claim 2, wherein said at least one line parameter comprises an operator-adjustable transmission profile to be used over a transmission line.

4. A line termination unit (1') according to claim 2, wherein said at least one line parameter comprises a measurable channel characteristic of a transmission line.

5. A line termination unit (1') according to claim 2, wherein said at least one line parameter comprises a communication parameter determined during past operation of a communication session over a transmission line.

6. A line termination unit (1') according to claim 2, wherein said at least one line parameter comprises a communication parameter determined during current operation of a communication session over a transmission line.

7. An access node comprising a line termination unit (1') according to any of the preceding claims.

## Patentansprüche

1. Leitungsabschlusseinheit (1'), umfassend:
- Eine Mehrzahl von Leitungstreibern (10) zum Antreiben von entsprechenden einer Mehrzahl von Übertragungsleitungen mit ersten Versorgungsspannungseingangsanschlüssen (11) und zweiten Versorgungsspannungseingangsanschlüssen (12),
- ein Stromversorgungsmittel (20) mit einem analogen Versorgungsspannungsausgangsanschluss (22) zur Versorgung eines analogen Teils der besagten Leitungsabschlusseinheit und mindestens einem digitalen Versorgungsspannungsausgangsanschluss (23a, 23b, 23c) zur Versorgung eines digitalen Teils der besagten Leitungsabschlusseinheit, und
- eine Erdspannungsreferenz (30),
wobei der besagte analoge Versorgungsspannungsausgangsanschluss an den besagten ersten Versorgungsspannungseingangsanschluss gekoppelt ist,
und wobei die besagte Leitungsabschlusseinheit weiterhin eine Auswahleinrichtung (40) zum selektiven und individuellen Koppeln eines jeden der besagten zweiten Versorgungsspannungseingangsanschlüsse an einen der besagten mindestens einen digitalen Versorgungsspannungsausgangsanschlüsse oder an die besagte Erdspannungsreferenz umfasst.

2. Leitungsabschlusseinheit (1') nach Anspruch 1, weiterhin umfassend eine Steuereinheit (50) zum Steuern des Betriebs der besagten Auswahleinrichtung gemäß mindestens einem Leitungsparameter.

3. Leitungsabschlusseinheit (1') nach Anspruch 2, wobei der besagte mindestens eine Leitungsparameter ein über eine Übertragungsleitung zu verwendendes betreiberseitig anpassbares Übertragungsprofil umfasst.

4. Leitungsabschlusseinheit (1') nach Anspruch 2, wobei der besagte mindestens eine Leitungsparameter eine messbare Kanaleigenschaft einer Übertragungsleitung umfasst.

5. Leitungsabschlusseinheit (1') nach Anspruch 2, wobei der besagte mindestens eine Leitungsparameter einen während eines vorherigen Vorgangs einer Kommunikationssitzung über eine Übertragungsleitung ermittelten Kommunikationsparameter umfasst.

6. Leitungsabschlusseinheit (1') nach Anspruch 2, wobei der besagte mindestens eine Leitungsparameter einen während eines momentanen Vorgangs einer Kommunikationssitzung über eine Übertragungsleitung ermittelten Kommunikationsparameter umfasst.

7. Zugangsknoten, umfassend eine Leitungsabschlusseinheit (1') gemäß einem beliebigen der vorstehenden Ansprüche.

## Revendications

1. Unité de terminaison de ligne (1') comprenant :
- une pluralité de circuits de commande de ligne (10) pour commander les lignes respectives d'une pluralité de lignes de transmission, avec des premières bornes d'entrée de tension d'alimentation (11) et des deuxièmes bornes d'entrée de tension d'alimentation (12),
- un moyen d'alimentation électrique (20), avec une borne de sortie de tension d'alimentation analogique (22) pour alimenter une partie analogique de ladite unité de terminaison de ligne, et au moins une borne de sortie de tension d'alimentation numérique (23a, 23b, 23c) pour alimenter une partie numérique de ladite unité de terminaison de ligne, et
- une référence de tension simple (30),
dans laquelle ladite borne de sortie de tension d'alimentation analogique est couplée à ladite première borne d'entrée de tension d'alimentation,
et dans laquelle ladite unité de terminaison de ligne comprend en outre un sélecteur (40) pour coupler de manière sélective et individuelle chacune desdites deuxièmes bornes d'entrée de tension d'alimentation à l'une desdites au moins une borne de sortie de tension d'alimentation numérique ou à ladite référence de tension simple.

2. Unité de terminaison de ligne (1') selon la revendication 1, et comprenant en outre un contrôleur (50) pour contrôler le fonctionnement dudit sélecteur conformément à au moins un paramètre de ligne.

3. Unité de terminaison de ligne (1') selon la revendication 2, dans laquelle ledit au moins un paramètre de ligne comprend un profil de transmission ajustable par un opérateur à utiliser sur une ligne de transmission.

4. Unité de terminaison de ligne (1') selon la revendication 2, dans laquelle ledit au moins un paramètre de ligne comprend une caractéristique de canal mesurable d'une ligne de transmission.

5. Unité de terminaison de ligne (1') selon la revendication 2,
dans laquelle ledit au moins un paramètre de ligne comprend un paramètre de communication déterminé au cours d'une activité précédente d'une session de communication sur une ligne de transmission.

6. Unité de terminaison de ligne (1') selon la revendication 2,
dans laquelle ledit au moins un paramètre de ligne comprend un paramètre de communication déterminé au cours d'une activité actuelle d'une session de communication sur une ligne de transmission.

7. Noeud d'accès comprenant une unité de terminaison de ligne (1) selon l'une quelconque des revendications précédentes.
